# FASCICULE DE BREVET EUROPEEN

(11) **EP 4 393 011 B1**
(45) Date de publication et mention de la délivrance du brevet: **26.11.2025**
(21) Numéro de dépôt: 22768338.0
(22) Date de dépôt: 19.08.2022
(51) Int. Cl.: H01L 23/498, H01L 23/538, H01L 23/00

(54) **STRUCTURE ÉLECTRONIQUE COMPRENANT UN FILM D'INTERCONNEXION**
ELEKTRONISCHE STRUKTUR MIT EINER VERBINDUNGSFOLIE
ELECTRONIC STRUCTURE COMPRISING AN INTERCONNECTION FILM

(30) Priorité: 23.08.2021 FR 2108819
(43) Date de publication de la demande: 03.07.2024
(73) Titulaire: Commissariat à l'Energie Atomique et aux Energies Alternatives, 75015 Paris (FR)
(72) Inventeur: SOURIAU, Jean-Charles, 38054 GRENOBLE CEDEX 09 (FR); DE GIROLAMO, Julia, 38054 GRENOBLE CEDEX 09 (FR); FOURNIER, Adeline, 38054 GRENOBLE CEDEX 09 (FR)
(74) Mandataire: Cabinet Camus Lebkiri
(86) Numéro de dépôt international: PCT/EP2022/073139
(87) Numéro de publication internationale: WO 2023/025667

(56) Documents cités:
- EP-A2- 3 364 456
- WO-A1-2019/042565
- KR-A- 20180 049 765

## Description

### DOMAINE TECHNIQUE

Le domaine technique de l'invention est celui de l'interconnexion électrique et mécanique d'un composant électronique sur un substrat, par exemple un substrat flexible capable de se déformer et de s'adapter à une surface non plane telle que la peau. La présente invention concerne plus particulièrement une structure électronique comprenant un substrat, un composant électronique et un film d'interconnexion disposé entre le substrat et le composant électronique.

### ÉTAT DE LA TECHNIQUE

Les structures électroniques souples peuvent intégrer des composants électroniques tels que des circuits intégrés, des capteurs, des actionneurs, des batteries, des composants passifs, des puces d'identification par radiofréquence (ou RFID, pour « radio frequency identification » en anglais) et des antennes. La fabrication d'une structure électronique souple comprend le report d'un ou plusieurs composants électroniques sur un substrat flexible, aussi appelé circuit imprimé flexible. Ce substrat comprend un film support, par exemple en polyester, polyimide, polytétrafluoroéthylène ou polyétheréthercétone, et des pistes métalliques disposées à la surface du film support. Chaque composant électronique comprend des plots de connexion qui débouchent sur une face du composant, cette face étant communément appelée « face active ».

Une premier technique d'interconnexion (appelée « wire bonding » en anglais) consiste à relier électriquement les plots de connexion du composant aux pistes métalliques du substrat par des fils, lorsque la face active du composant est tournée vers le haut.

Lorsqu'au contraire la face active du composant est tournée vers le bas (autrement dit lorsqu'elle est disposée en regard du substrat), les plots de connexion du composant peuvent être connectés aux pistes métalliques du substrat par brasage, à l'aide d'un matériau fusible, d'une colle conductrice ou d'un élément conducteur pressé sur chaque plot d'interconnexion. Cette deuxième technique d'interconnexion, électrique et mécanique, est communément appelée « flip-chip », en référence à la position retournée du composant. Des éléments d'interconnexion, tels que des microbilles fusibles, un film conducteur anisotrope ou des bossages en or (plus connu sous le nom de « stud bump »), peuvent être disposés entre le composant et le substrat.

Comme les composants électroniques sont souvent épais et rigides, les contraintes en flexion dans la structure électronique sollicitent fortement les interfaces de collage, de soudure ou de brasure, qui finissent par rompre.

Pour remédier à ce problème, il a été proposé de placer les interfaces ou éléments d'interconnexion au plus près du plan neutre de la structure électronique.

Par exemple, le brevet FR1857094B1 décrit une structure électronique souple comprenant un film en matériau polymère recouvert d'une piste métallique, un composant électronique, un élément d'interconnexion reliant électriquement et mécaniquement le composant électronique à la piste métallique et une couche de compensation discontinue pour amener le plan neutre au niveau de l'élément d'interconnexion.

Le document US2006/097373 décrit par ailleurs une structure électronique comprenant un substrat flexible et un composant électronique collé au substrat au moyen d'une couche de résine thermodurcissable, typiquement une résine époxy. Un pilier conducteur relie électriquement un plot de connexion aménagé dans la face active du composant et une piste métallique disposée sur le substrat flexible. Ce pilier conducteur s'étend à travers la couche de résine thermodurcissable. La structure électronique comprend en outre une couche isolante dite de passivation, dont l'épaisseur est choisie pour amener le plan neutre de la structure au niveau de la face active du composant.

Ces agencements permettent de limiter les contraintes mécaniques en flexion au niveau de la connexion électrique du composant (autrement dit lorsque la structure électronique est pliée). En revanche, ils ne sont pas totalement satisfaisants lorsque la structure électronique est soumise à des contraintes de traction (étirement) ou de cisaillement. Le document KR20180049765 décrit un dispositif électronique, comprenant un corps principal du dispositif disposé sur un premier côté d'un film de base flexible, une unité de contact disposée sur un second côté du film de base, et une structure de montage à sec disposée du côté de la partie principale de l'unité de contact et sur le second côté du film de base.

### RESUMÉ DE L'INVENTION

Il existe donc un besoin de prévoir une structure électronique ayant une durée de vie améliorée par rapport aux structures de l'art antérieur, grâce notamment à une meilleure résistance aux contraintes de traction (étirement) et/ou de cisaillement.

Selon un premier aspect de l'invention, on tend à satisfaire ce besoin en prévoyant une structure électronique selon la revendication 1.

Le film d'interconnexion comprend une première face, une deuxième face opposée à la première face, une zone électriquement conductrice s'étendant de la première face à la deuxième face et un matériau polymère électriquement isolant enrobant la zone électriquement conductrice, au moins l'une des première et deuxième faces du film d'interconnexion étant structurée de manière à former un film d'adhésif sec, ladite au moins une des première et deuxième faces présentant une pluralité de motifs, une partie au moins des motifs étant formés du matériau polymère électriquement isolant.

Dans un mode de réalisation préférentiel, les motifs sont en forme de champignon, chaque motif en forme de champignon comprenant un pilier surmonté d'un chapeau, le chapeau ayant, dans un plan parallèle au substrat, des dimensions supérieures à celles du pilier.

Dans une variante de réalisation, les motifs sont des piliers de section constante sur toute leur hauteur ou de section croissante en s'éloignant d'un plan médian du film d'interconnexion.

La structure électronique selon le premier aspect de l'invention peut également présenter une ou plusieurs des caractéristiques ci-dessous, considérées individuellement ou selon toutes les combinaisons techniquement possibles :
- le pilier des motifs présente une hauteur comprise entre 5 µm et 200 µm et des dimensions comprises entre 1 µm et 100 µm dans un plan parallèle au substrat ;
- le chapeau des motifs présente une hauteur comprise entre 1 µm et 2 µm et, dans un plan parallèle au substrat, des dimensions maximales égales aux dimensions du pilier augmentées d'une valeur comprise entre 1 µm et 6 µm ;
- une partie au moins des motifs sont électriquement conducteurs et appartiennent à la zone électriquement conductrice ;
- les motifs présentent un premier pas de répétition dans une première direction et un deuxième pas de répétition dans une deuxième direction différente de la première direction ;
- le substrat comprend une piste électriquement conductrice, le composant électronique comprend un plot de connexion et la zone électriquement conductrice relie la piste électriquement conductrice au plot de connexion ;
- la zone électriquement conductrice comprend des nanofils de carbone, des nanotubes de carbone, du noir de carbone, des particules métalliques ou du graphène ;
- le film d'interconnexion est flexible et/ou étirable ;
- le film d'interconnexion est capable de subir, sans rompre, une flexion d'un rayon de courbure inférieur ou égal à 1000 mm ;
- le film d'interconnexion est capable de s'allonger sous sollicitation mécanique de plus de 5 % sans rompre ;
- le matériau polymère électriquement isolant est du parylène ou un élastomère, par exemple du polyuréthane, du polyuréthane-acrylate, du polyvinylsiloxane, du polypropylène, de l'acide polylactique-co-glycolique ou un élastomère de silicone tel que le polydiméthylsiloxane (PDMS) ou le silicone polyaddition ;
- le composant électronique est recouvert entièrement par une couche d'encapsulation constituée du matériau polymère électriquement isolant.

Un deuxième aspect de l'invention concerne un procédé de fabrication d'une structure éelectronique selon la revendication 10.

Dans un mode de mise en œuvre préférentiel du procédé de fabrication, l'étape de fourniture du film d'interconnexion comprend les sous-étapes suivantes :
- fournir un moule comprenant des cavités ;
- déposer un matériau électriquement conducteur dans une région du moule, formant ainsi une zone électriquement conductrice ;
- déposer un matériau polymère électriquement isolant dans le moule de manière à enrober la zone électriquement conductrice ; et
- démouler le film d'interconnexion.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes :
la figure 1 représente schématiquement un premier mode de réalisation d'une structure électronique selon le premier aspect de l'invention ;
la figure 2 représente schématiquement un deuxième mode de réalisation de la structure électronique ;
la figure 3 représente schématiquement un troisième mode de réalisation de la structure électronique ;
la figure 4 représente en vue de face un exemple de film d'interconnexion appartenant à la structure électronique ;
la figure 5 représente schématiquement un quatrième mode de réalisation de la structure électronique ;
la figure 6 représente schématiquement un cinquième mode de réalisation de la structure électronique ;
les figures 7A à 7C représentent des étapes d'un procédé de fabrication de structure électronique selon le deuxième aspect de l'invention ; et
les figures 8A à 8E représentent des étapes de fabrication d'un film d'interconnexion.

Pour plus de clarté, les éléments identiques ou similaires sont repérés par des signes de référence identiques sur l'ensemble des figures.

### DESCRIPTION DÉTAILLÉE

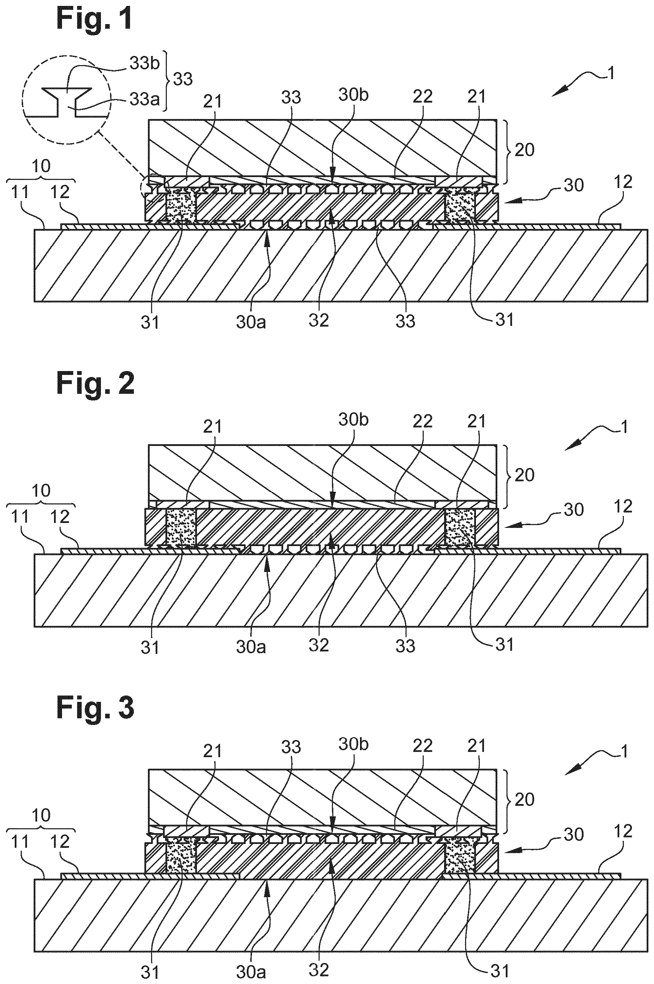

Les figures 1 à 3, 5 et 6 représentent en vue de coupe schématique différents modes de réalisation d'une structure électronique 1.

D'une manière commune à tous ces modes de réalisation, la structure électronique 1 comprend un substrat 10, un composant électronique 20 et un film d'interconnexion 30 disposé entre le substrat 10 et le composant électronique 20. En l'absence de contraintes mécaniques, le substrat 10, le composant électronique 20 et le film d'interconnexion 30 s'étendent selon des plans parallèles.

Le substrat 10 est avantageusement flexible, c'est-à-dire qu'il peut subir, sans rompre, une flexion d'un rayon de courbure inférieur ou égal à 1000 mm. De préférence, le substrat 10 peut subir sans rompre une flexion d'un rayon de courbure inférieur ou égal à 200 mm et plus préférentiellement encore inférieur ou égal à 50 mm. Un substrat 10 flexible confère de la souplesse à la structure électronique 1, ce qui lui permet d'être positionnée sur un support non plan ou sur une surface qui se déforme dans le temps, comme un corps en mouvement. La structure électronique 1 trouve ainsi de nombreuses applications dans le domaine médical en tant que patch porté par une personne, par exemple sur un poignet, un bras ou un torse.

A titre d'exemple, la structure électronique 1 peut faire partie d'un système de mesure de la température, de la fréquence cardiaque, de la pression artérielle ou du taux d'oxygène, d'un système d'actimétrie (mesure et analyse des mouvements), d'un système de mesure de la sécrétion de la peau (ex. sueur), d'un système de stimulation électrique ou optique, ou encore d'un système d'administration de médicament (aussi appelé patch transdermique).

La structure électronique 1 elle-même peut être qualifiée de flexible (ou souple) lorsqu'elle est capable de fléchir jusqu'à présenter un rayon de courbure inférieur ou égal à 1000 mm (de préférence inférieur ou égal à 200 mm et plus préférentiellement encore inférieur ou égal à 50 mm) sans subir de dommage.

Le substrat 10 comprend de préférence un film support 11 et au moins une piste électriquement conductrice 12 disposée sur le film support 11. Le substrat 10 peut être également appelé circuit imprimé.

Dans la description qui suit, on considérera que le substrat 10 comprend une pluralité de pistes électriquement conductrices 12, appelées ci-après pistes électriques. Dans un souci de simplification, seules deux pistes électriques 12 ont été représentées dans le plan de coupe des figures 1 à 3, 5 et 6 (ce plan de coupe étant perpendiculaire aux plans du substrat 10, du composant électronique 20 et du film d'interconnexion 30).

Le film support 11 est avantageusement constitué d'un matériau souple, c'est-à-dire un matériau présentant un module de Young inférieur ou égal à 10 GPa, et de préférence inférieur ou égal 5 GPa. Le film support 11 est de préférence en un matériau polymère, par exemple un polyester tel que le polyéthylène naphtalate (ou PEN) ou le polytéréphtalate d'éthylène (PET), un polyimide (PI), le polytétrafluoroéthylène (PTFE), le polyétheréthercétone (PEEK), le polycarbonate (PC) ou le polyéther sulfone (PES).

Le tableau suivant donne un ordre de grandeur du module de Young E de ces matériaux polymère.

**[Tableau 1]**

| Matériau polymère | PEN | PET | PI | PTFE | PEEK | PC | PES |
|---|---|---|---|---|---|---|---|
| Module de Young (GPa) | 0,5 à 1,5 | 2,8 à 3,1 | 2 à 8 | 0,5 | 3 à 4 | 2 à 2,4 | 2,6 |

Alternativement, le film support 11 est en un matériau rigide (> 50 GPa), par exemple en verre, en céramique, en silicium ou en métal. Le film support 11 peut toutefois présenter une épaisseur permettant au substrat 10 de remplir la condition de flexion sans rupture indiquée ci-dessus.

L'épaisseur du film support 11 est de préférence comprise entre 50 µm et 250 µm lorsqu'il est en un matériau souple (ex. matériau polymère) et inférieure à 100 µm lorsqu'il est en un matériau rigide tel que le verre ou le silicium.

Les pistes électriques 12 peuvent être métalliques, par exemple en cuivre (Cu), argent (Ag), or (Au), aluminium (AI), tungstène (W), nickel (Ni), platine (Pt), titane (Ti) ou ruthénium (Ru). Elles peuvent être réalisées par dépôt et gravure d'une ou plusieurs couches de métal, par sérigraphie à partir d'une pâte ou encre chargée en particules métalliques ou par voie additive (jet de matière, impression 3D). Chaque piste électrique 12 peut être constituée d'une seule couche ou d'un empilement de plusieurs couches ayant des fonctions différentes (ex. couche d'accroche, couche de barrière de diffusion et couche de finition inerte). L'épaisseur des pistes électriques 12 peut être comprise entre 50 nm et 5 µm, et de préférence entre 100 nm et 2 µm.

En complément ou en remplacement des pistes électriques 12, le substrat 10 peut comprendre au moins un plot de connexion et/ou au moins un via conducteur (non représentés sur les figures). Chaque piste électrique 12 s'étend à la surface du film support 11 alors que chaque plot de connexion et chaque via conducteur s'étendent à l'intérieur du film support 11. A la différence du plot de connexion (situé par exemple à l'extrémité d'une piste électrique 12), le via conducteur est traversant, c'est-à-dire qu'il s'étend d'une face à l'autre du film support 11.

Le composant électronique 20 peut être un circuit intégré (par exemple un circuit intégré à application spécifique (ou ASIC, pour « application-specific integrated circuit » en anglais), un capteur (de température, de fréquence cardiaque...), un actionneur, un stimulateur, une microbatterie ou une puce RFID. Son épaisseur est avantageusement inférieure ou égale à 350 µm, de préférence inférieure ou égale à 100 µm, afin de maximiser les propriétés de souplesse de la structure électronique 1.

Le composant électronique 20 comprend au moins un plot de connexion 21 débouchant sur une face dite active du composant (autrement dit, une partie de la face active est formée par le plot de connexion 21). Le plot de connexion 21 est de préférence enrobé dans une couche diélectrique 22. Il forme avantageusement une surface plane avec la couche diélectrique 22. La couche diélectrique 22, aussi appelée couche de passivation, est constituée d'un matériau électriquement isolant.

Comme illustré sur les figures, le composant électronique 20 peut comprendre une pluralité de plots de connexion 21 distincts et contenus dans la couche diélectrique 22. Les plots de connexion 21 constituent typiquement les bornes d'entrée et de sortie du composant électronique 20.

Les plots de connexion 21 sont de préférence en métal, par exemple en cuivre (Cu), argent (Ag), or (Au), aluminium (AI), alliage d'aluminium de type AlSi ou AlCu, tungstène (W), nickel (Ni), platine (Pt), titane (Ti) ou ruthénium (Ru).

La face active du composant électronique 20 est tournée vers le substrat 10. Ainsi, le composant électronique 20 est interconnecté au substrat 10 selon une technique d'interconnexion de type « flip-chip ».

Le film d'interconnexion 30 relie électriquement et mécaniquement le composant électronique 20 au substrat 10. Il comprend une première face 30a et une deuxième face 30b opposée à la première face 30a. La première face 30a est disposée en contact avec le substrat 10, tandis que la deuxième face 30b est disposée en contact avec le composant électronique 20.

Le film d'interconnexion 30 comprend une ou plusieurs zones électriquement conductrices 31 qui s'étendent de la première face 30a à la deuxième face 30b. Au moins une zone électriquement conductrice 31, aussi appelée zone d'interconnexion électrique, assure la connexion électrique entre le composant électronique 20 et le substrat 10. Plus particulièrement, une zone d'interconnexion électrique 31 peut être agencée pour relier électriquement une piste métallique 12 du substrat 10 à un plot de connexion 21 du composant électronique 20. En variante, une zone d'interconnexion électrique 21 peut relier un plot de connexion ou un via conducteur du substrat 10 à un plot de connexion 21 du composant électronique 20. De préférence, le film d'interconnexion 30 comprend plusieurs zones d'interconnexion électrique 31.

Le film d'interconnexion 30 comprend en outre un matériau polymère 32, électriquement isolant, qui enrobe (ou entoure) les zones électriquement conductrices 31. Le matériau polymère 32 constitue ainsi une ou plusieurs zones électriquement isolantes qui séparent les zones électriquement conductrices 31.

Ce matériau polymère 32 permet au film d'interconnexion 30 de s'étirer, de se comprimer et/ou de se tordre. Le film d'interconnexion 30 est donc un film flexible (rayon de courbure inférieur ou égal à 1000 mm, de préférence inférieur ou égal à 200 mm et plus préférentiellement encore inférieur ou égal à 50 mm) et/ou étirable. On entend par « étirable » un film qui peut s'allonger sous sollicitation mécanique de plus de 5 %. De préférence, le matériau polymère 32 représente plus de 50 % du volume total du film d'interconnexion 30. Le volume restant du film d'interconnexion 30 est avantageusement constitué par les zones électriquement conductrices 31.

Le matériau polymère 32 du film d'interconnexion 30 est de préférence un parylène ou un élastomère. Le matériau élastomère peut être le polyuréthane, le polyuréthane-acrylate, le polyvinylsiloxane, le polypropylène ou l'acide polylactique-co-glycolique (PLGA) ou un élastomère de silicone tel que le polydiméthylsiloxane (PDMS) ou le silicone polyaddition (aussi appelé « platinum silicone »).

Les zones électriquement conductrices 31 comprennent un matériau électriquement conducteur, de préférence choisi parmi des nanofils de carbone, des nanotubes de carbone, du noir de carbone, des particules métalliques ou du graphène. Ce matériau électriquement conducteur peut être utilisé seul ou en mélange avec un matériau polymère, identique ou différent du matériau polymère 32 formant la base du film d'interconnexion 30.

Grâce au film d'interconnexion 30 constitué principalement du matériau polymère 32, la structure électronique 1 présente une excellente résistance aux contraintes mécaniques, en particulier aux contrainte de traction (étirement), de flexion et de cisaillement.

La structure électronique 1 est en outre remarquable en ce qu'au moins une des première et deuxième faces 30a-30b du film d'interconnexion 30 est structurée de manière à former un film d'adhésif sec. Un adhésif sec, parfois appelé ruban gecko (« gecko tape » en anglais), est un produit adhésif inspiré des pattes du gecko et dont le pouvoir d'adhésion repose sur des forces de Van der Waals générées par une micro-structuration en surface d'un matériau (typiquement un matériau polymère). Ainsi, le film d'interconnexion 30 présente tout ou partie des propriétés d'un adhésif sec. Les propriétés d'un adhésif sec sont une adhésion directionnelle (ou anisotrope), une fixation robuste avec une précharge mécanique minimale, un détachement facile, un auto-nettoyage (absence de résidus laissés sur la surface), une forte capacité de réutilisation et un état par défaut non-adhérent.

Les adhésifs secs sont de bons adhésifs principalement dans le cas d'une sollicitation perpendiculaire (« pull-off ») ou latérale (cisaillement) mais moins bons dans le cas d'un pelage avec un angle de pelage élevé. Ce sont aussi des adhésifs respirants (avantageux dans le cas d'une utilisation directe sur la peau).

Dans les modes de réalisation représentés par les figures 1 à 3, 5 et 6, la structuration du film d'interconnexion 30 consiste en une pluralité de motifs 33 en forme de champignon, semblables aux setae en forme de spatule du gecko. Chaque motif 33 en forme de champignon comprend un pilier 33a (formant le pied du champignon) surmonté d'un chapeau 33b (aussi appelé collerette). Les motifs 33 ont de préférence des dimensions identiques (aux tolérances de fabrication près).

Le pilier 33a des motifs 33 s'étend de préférence dans une direction perpendiculaire au substrat 10. Il présente, dans un plan parallèle au substrat 10, une section qui est avantageusement constante sur toute la hauteur du pilier (piliers de forme cylindrique) ou décroissante en s'éloignant du plan médian du film d'interconnexion 30 (piliers de forme tronconique). Cette section est par exemple ronde, rectangulaire (carrée notamment) ou hexagonale.

Les dimensions de la section du pilier 33a (mesurées dans un repère orthonormé) sont avantageusement comprises entre 1 µm et 100 µm, de préférence entre 5 µm et 20 µm. La hauteur du pilier 33a (mesurée perpendiculairement au plan du substrat 10) peut être comprise entre 5 µm et 200 µm, de préférence entre 10 µm et 100 µm.

Le chapeau 33b des motifs 33 est en contact avec le substrat 10 ou le composant électronique 20 (selon que les motifs 33 appartiennent à la première face 30a ou à la deuxième face 30b). Le chapeau 33b présente, dans un plan parallèle au substrat 10, une section dont les dimensions sont supérieures à celles du pilier 33a. Cette section, de préférence ronde ou ovale, peut être constante sur toute la hauteur du chapeau ou croissante en s'éloignant du sommet du pilier 33a, comme cela est représenté sur les figures (voir plus particulièrement l'agrandissement de la figure 1). Les dimensions maximales du chapeau 33b, à son sommet (c'est-à-dire à l'extrémité distale du motif 33, au contact avec le substrat 10 ou le composant électronique 20) sont de préférence égales aux dimensions du pilier 33a plus une valeur δ comprise entre 1 µm et 6 µm. Ainsi, on aura par exemple d2 = d1+δ dans le cas d'un pilier 33a de section ronde (diamètre d1) et d'un chapeau 33b de section ronde (diamètre d2) ou x2 = x1+δ et y2 = y1+δ dans le cas d'un pilier 33a de section rectangulaire (dimensions x1, y1) et d'un chapeau 33b de section ovale (dimensions x2, y2). La hauteur du chapeau 33b est de préférence comprise entre 1 µm et 2 µm.

Dans une variante de réalisation non représentée par les figures, les motifs 33 sont des piliers de section constante sur toute leur hauteur (piliers cylindriques) ou de section croissante en s'éloignant du plan médian du film d'interconnexion 30 (piliers tronconiques). La section des piliers est par exemple ronde, rectangulaire (carrée notamment) ou hexagonale. Les piliers s'étendent de préférence perpendiculairement au plan (médian) du film d'interconnexion 30.

Une partie au moins des motifs 33 sont formés du matériau polymère 32 électriquement isolant afin d'assurer l'adhésion sèche du film d'interconnexion 30. D'autres motifs 33 peuvent au contraire être électriquement conducteurs et appartenir aux zones électriquement conductrices 31. Les motifs 33 améliorent la résistance des éléments d'interconnexion électrique aux contraintes mécaniques, en particulier aux contraintes de traction, cisaillement et/ou flexion.

Dans une variante de réalisation non représentée par les figures, tout ou partie des zones électriquement conductrices 31 sont dépourvues de motifs 33.

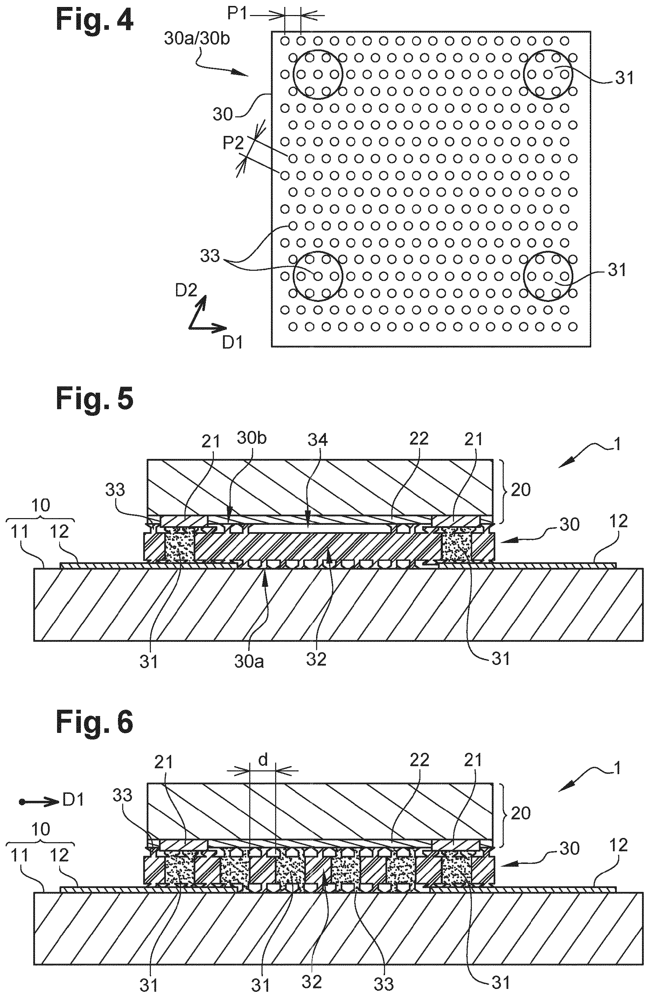

En référence à la figure 4, les motifs 33 sont de préférence répartis de manière régulière sur la première face 30b et/ou sur la deuxième 30b du film d'interconnexion 30, afin d'obtenir une adhésion homogène. Ils présentent un premier pas de répétition P1 dans une première direction D1 et un deuxième pas de répétition dans une deuxième direction D2 différente de la première direction. Le deuxième pas de répétition P2 peut être égal au premier pas de répétition P1.

L'ensemble des motifs 33 présents sur une face du film d'interconnexion 30 constitue ainsi un réseau. Le réseau de motifs 33 peut notamment être à maille rectangulaire (directions D1-D2 perpendiculaires), carrée (directions D1-D2 perpendiculaires et pas de répétition P1-P2 égaux) ou en forme de parallélogramme (angle entre les directions D1-D2 compris entre 0° et 90° exclus). Le réseau de motifs 33 peut occuper tout ou partie de la face du film d'interconnexion 30. Il occupe avantageusement plus de 50 %, et de préférence plus de 90 %, de la superficie de la face du film d'interconnexion 30.

Dans le mode de réalisation de la figure 1, les motifs 33 sont présents sur la première face 30a et sur la deuxième face 30b du film d'interconnexion 30. Ainsi, une adhésion sèche est obtenue à la fois avec le substrat 10 et le composant électronique 20. Le film d'interconnexion 30 comprend de préférence deux réseaux de motifs 33. Chaque réseau de motifs 33 occupe avantageusement plus de 50 % (de préférence plus de 90 %) de la superficie des première et deuxième faces 30a-30b. La force d'adhésion et la résistance aux contraintes mécaniques sont alors maximales.

Dans le mode de réalisation de la figure 2, les motifs 33 sont présents uniquement sur la première face 30a du film d'interconnexion 30. Ainsi, une adhésion sèche est obtenue uniquement avec le substrat 10. Les motifs 33 sont avantageusement agencés en un réseau qui occupe plus de 50 % (de préférence plus de 90 %) de la superficie de la première face 30a.

A l'inverse, dans le mode de réalisation de la figure 3, les motifs 33 sont présents uniquement sur la deuxième face 30b du film d'interconnexion 30. Ainsi, une adhésion sèche est obtenue uniquement avec le composant électronique 20. Les motifs 33 sont avantageusement agencés en un réseau qui occupe plus de 50 % (de préférence plus de 90 %) de la superficie de la deuxième face 30b.

La figure 4 est une vue de face d'un exemple de réalisation du film d'interconnexion 30, dans lequel les motifs 33 sont agencés selon un réseau ayant une maille en forme de parallélogramme (et plus exactement de losange). Les motifs 33 ont par ailleurs un chapeau de section ronde. La distance entre deux motifs 33 consécutifs dans le réseau est égale au diamètre (maximal) du chapeau (d'où des pas de répétition P1, P2 égaux au double du diamètre du chapeau). Cet exemple de réalisation de film d'interconnexion 30 est notamment compatible avec les trois modes de réalisation de la structure électronique 1 décrits précédemment (en relation avec les figures 1 à 3).

Par ailleurs, les faces 30a-30b du film d'interconnexion 30 ont dans cet exemple une forme de rectangle et le film d'interconnexion 30 comprend quatre zones électriquement conductrices 31 disposées à proximité des coins du rectangle.

Dans le mode de réalisation de la figure 5, une région 34 de la deuxième face 30b est dépourvue de motifs 33. Cette région 34 peut être située en regard d'une zone sensible du composant électronique 20, comme une zone photosensible ou une zone comportant un élément mobile. Une région de la première face 30a peut être également dépourvue de motifs 33.

Dans le mode de réalisation de la figure 6, le film d'interconnexion 30 comprend une densité de zones électriquement conductrices 31 suffisamment élevée pour pouvoir être placé sans alignement entre le substrat 10 et le composant électronique 20. Il est alors plus facile d'assembler la structure électronique 1. Certaines zones électriquement conductrices 31 peuvent ne pas servir d'éléments d'interconnexion électrique entre le substrat 10 et le composant électronique 20. Les zones électriquement conductrices 31 peuvent occuper jusqu'à 50 % de la superficie des première et deuxième faces 30a-30b.

Les zones électriquement conductrices 31 sont de préférence régulièrement espacées dans une direction au moins, par exemple la première direction D1, et plus préférentiellement encore dans deux directions perpendiculaires. La distance d qui sépare deux zones électriquement conductrices 31 consécutives (dans chaque direction) peut être comprise entre 5 µm et 200 µm, avantageusement entre 30 µm et 100 µm. Le film d'interconnexion 30 s'apparente alors à un film conducteur anisotrope.

Pour éviter de devoir aligner le film d'interconnexion 30 entre le substrat 10 et le composant électronique 20, le film d'interconnexion 30 peut comporter une matrice de zones conductrices 31 (par exemple en forme de cylindres) dont le pas de répétition (dans chaque direction) est inférieur à la dimension des plots de connexion 21 (dans ladite direction).

Le mode de réalisation de la figure 6 est combinable avec l'un quelconque des modes de réalisation décrits précédemment.

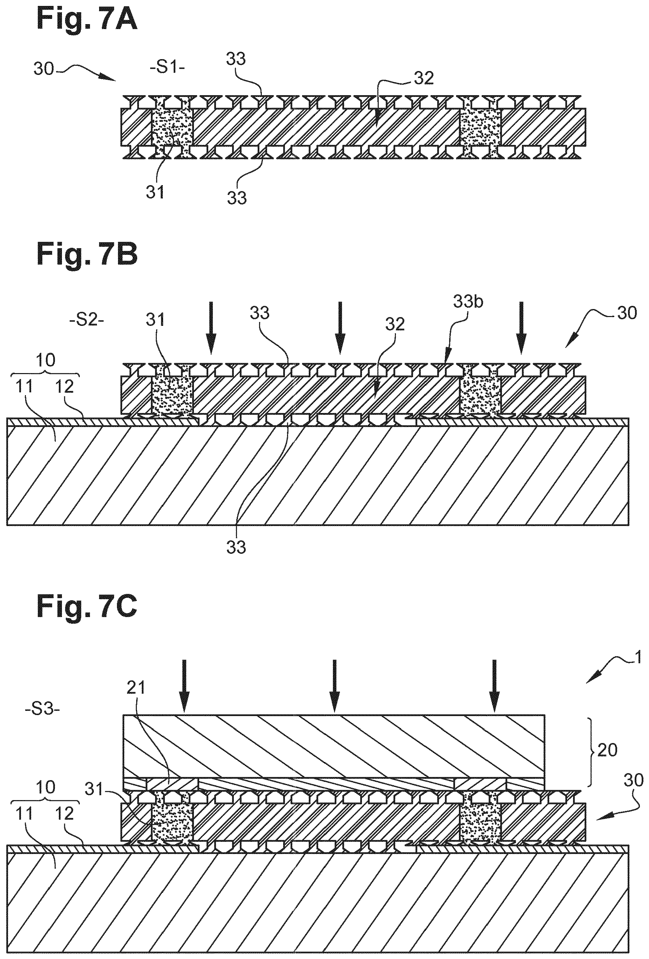

Les figures 7A à 7C illustrent des étapes S1 à S3 d'un procédé de fabrication (ou d'assemblage) de la structure électronique 1.

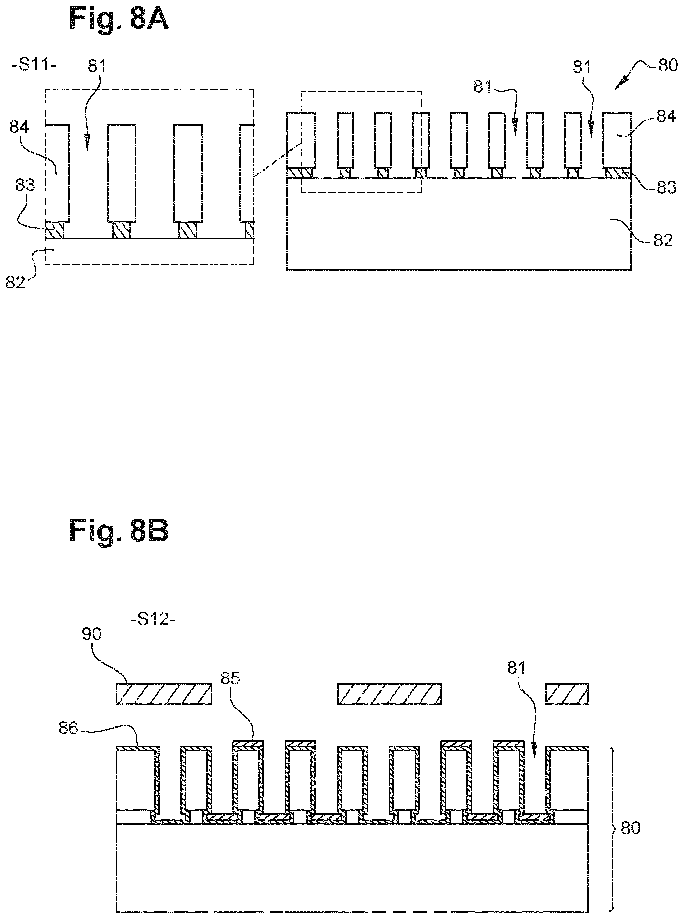

L'étape S1 de la figure 7A consiste à fournir ou fabriquer le film d'interconnexion 30. Une façon préférentielle de fabriquer le film d'interconnexion 30 sera décrite ultérieurement en relation avec les figures 8A-8E.

Puis, à l'étape S2 de la figure 7B, le film d'interconnexion 30 est reporté sur le substrat 10. Une pression est avantageusement appliquée sur la deuxième face 30b du film d'interconnexion 30 afin de maximiser la force d'adhésion avec le substrat 10 (par exemple en maximisant le nombre de motifs 33 en contact avec le substrat 10).

Plus particulièrement, le film d'interconnexion 30 peut être positionné sur le substrat 10 de sorte qu'au moins une zone électriquement conductrice 31 du film d'interconnexion 30 vienne en contact avec une piste électrique 12 (un plot de connexion ou un via) du substrat 10.

Enfin, lors d'une étape S3 dite d'hybridation représentée par la figure 7C, le composant électronique 20 est reporté sur le film d'interconnexion 30. Plus particulièrement, le composant électronique 20 est positionné sur le film d'interconnexion 30 de sorte que chaque plot de connexion 21 (chaque borne d'entrée/sortie) du composant électronique 20 vienne en contact avec une zone électriquement conductrice 31 du film d'interconnexion 30 (elle-même en contact avec une piste métallique 12 du substrat 10). A nouveau, une pression peut être exercée sur la face supérieure du composant électronique 20 (face opposée à la face active/inférieure).

Plutôt que d'appliquer séparément des pressions sur le film d'interconnexion 30 (étape S2) et sur le composant électronique 20 (étape S3), une contrainte de compression (perpendiculaire au plan du substrat 10) peut être appliquée à la structure électronique 1 après l'étape d'hybridation S3 du composant électronique 20.

Enfin, le procédé de fabrication peut comprendre une étape d'encapsulation du composant électronique 20 sur le substrat 10. Cette étape d'encapsulation peut comprendre la formation d'une couche diélectrique (dite d'encapsulation) sur le substrat 10 et le composant électronique 20, de manière à recouvrir entièrement le composant électronique 20 (sa face supérieure et ses parois latérales). La couche diélectrique peut être en céramique ou en un matériau polymère. Le matériau polymère d'encapsulation est avantageusement identique au matériau polymère 32 du film d'interconnexion 30.

Les figures 8A à 8E représentent des étapes S11 à S15 d'un procédé de fabrication du film d'interconnexion 30.

L'étape S11 de la figure 8A consiste à prévoir un moule 80 comprenant des cavités 81 pour former les motifs 33 (ici en forme de champignon). Le moule 80 est avantageusement réalisé à partir d'un substrat silicium sur isolant (SOI), par exemple de la façon décrite dans le document [« Bioinspired, Highly Stretchable, and Conductive Dry Adhesives Based on 1D-2D Hybrid Carbon Nanocomposites for All-in-One ECG Electrodes », ACS Nano 2016, 10, 4, 4770-4778]. Le substrat SOI comprend une couche de support 82 en silicium, une couche d'oxyde enterrée 83 (ou couche BOX, pour « Burried Oxyde Layer » en anglais) disposée sur la couche de support 82 et un film mince de silicium 84 disposée sur la couche BOX 83.

La formation des cavités 81 du moule 80 peut ainsi comprendre une sous-étape de formation d'un masque sur le substrat SOI, une sous-étape de gravure anisotrope (par exemple par gravure ionique réactive profonde ou DRIE) du film mince de silicium 84 à travers le masque jusqu'à atteindre la couche BOX 83 sous-jacente, une étape de retrait du masque, et enfin une sous-étape de gravure isotrope (par exemple une gravure humide dans un bain d'acide fluorhydrique) de la couche BOX 83 sélectivement par rapport à la couche de support 82 et au film mince de silicium 84. La portion des cavités 81 située dans le film mince de silicium 84 est destinée à former le pilier des motifs 33, tandis que la portion des cavités 81 située dans la couche BOX 83 est destinée à former le chapeau des motifs 33.

Un matériau électriquement conducteur est ensuite déposé dans une ou plusieurs régions distinctes du moule 80, pour former les zones électriquement conductrices 31 du film d'interconnexion 30. De préférence, le matériau électriquement conducteur est déposé dans des régions du moule 80 munies de cavités 81.

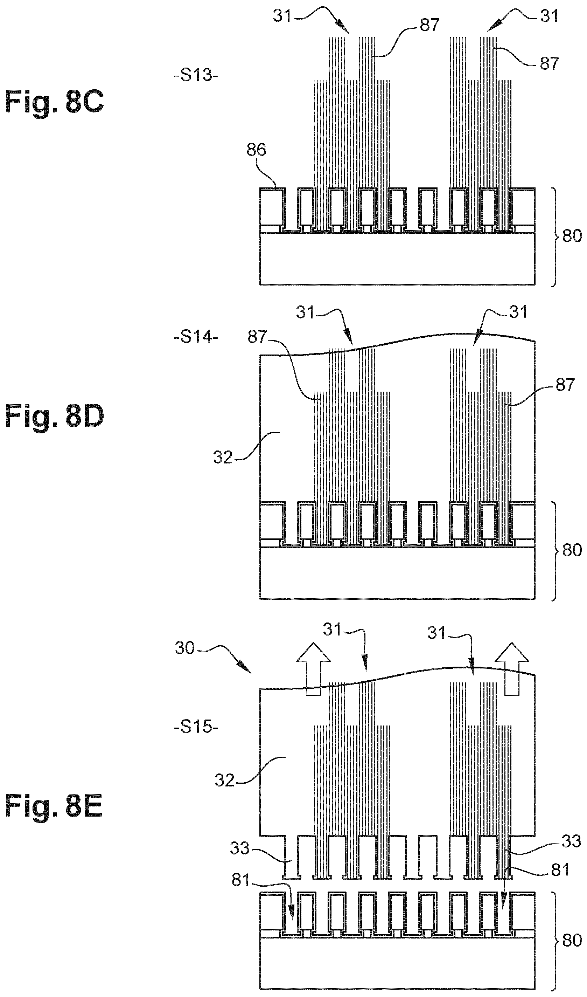

Les figures 8B et 8C représentent, à titre d'exemple, la croissance localisée de nanotubes de carbone dans le moule 80. A l'étape S12 de la figure 8B, un catalyseur 85 est déposé dans les régions du moule 81, par exemple au travers d'un masque perforé 90 (ou « shadow mask » en anglais). Le catalyseur 85, par exemple du fer, peut être déposé par évaporation sous vide. Le dépôt du catalyseur 85 peut être précédé du dépôt d'une couche d'alumine 86 sur le moule 80, par exemple par dépôt de couches atomiques (ou ALD). Puis, à l'étape S13 de la figure 8C, on fait croître des nanotubes de carbone 87 à partir du catalyseur 85, de préférence par dépôt chimique en phase vapeur (CVD) assistée par filaments chauds.

Selon une variante de mise en œuvre, le matériau électriquement conducteur est un mélange de matériau polymère et de particules conductrices (particules métalliques, noir de carbone...). Il est déposé de manière localisée sur le moule 80, par exemple au travers d'un masque.

L'étape S14 de la figure 8D comprend l'enrobage des zones électriquement conductrices 31 (ici formées des nanotubes de carbone 87) par le matériau polymère 32 électriquement isolant. Le matériau polymère 32, initialement sous forme liquide, est déposé (coulé) sur le moule 81 autour des zones électriquement conductrices 31, puis durcit ou réticulé (dans des conditions propres à chaque matériau polymère).

Enfin, à l'étape S15 de la figure 8E, le film comprenant les zones électriquement conductrices 31 enrobées du matériau polymère 32 est extrait du moule 80. Il constitue un film d'interconnexion 30 ayant une seule face structurée (motifs 33 dont la forme et les dimensions correspondent aux cavités 81 du moule 80).

Pour obtenir un film d'interconnexion 30 dont les deux faces sont structurées, deux films tels que représentés par la figure 8E peuvent être fabriqués puis couplés entre eux (au niveau de leur face non-structurée), par exemple par activation de surface de type plasma puis assemblage par pression.

De nombreuses variantes et modifications de la structure électronique et de son procédé de fabrication apparaîtront à l'homme du métier. En particulier, le substrat 10 peut ne pas être flexible. Dans ce cas, le film d'interconnexion 30 est avantageux pour absorber des contraintes mécaniques dues à la différence des coefficients de dilatation thermique entre le substrat 10 et le composant électronique 20.

## Revendications

1. Structure électronique (1) comprenant :
- un substrat (10) comprenant :
∘ un film support (11) ; et
∘ une piste électriquement conductrice (12) disposée sur le film support (11) ou un plot de connexion s'étendant à l'intérieur du film support (11) ou un via conducteur s'étendant à l'intérieur du film support (11) ;
- un composant électronique (20) ;
- un film d'interconnexion (30) disposé entre le substrat (10) et le composant électronique (20), reliant électriquement et mécaniquement le composant électronique au substrat, le film d'interconnexion (30) comprenant :
∘ une première face (30a) ;
∘ une deuxième face (30b) opposée à la première face ;
∘ une zone électriquement conductrice (31) s'étendant de la première face (30a) à la deuxième face (30b) et assurant une connexion électrique entre le composant électronique (20) et le substrat (10) ;
∘ un matériau polymère (32) électriquement isolant enrobant la zone électriquement conductrice (31),
au moins l'une des première et deuxième faces (30a, 30b) du film d'interconnexion (30) étant structurée de manière à former un film d'adhésif sec, ladite au moins une des première et deuxième faces (30a, 30b) présentant une pluralité de motifs (33), les motifs (33) étant des piliers de section croissante en s'éloignant d'un plan médian du film d'interconnexion (30) ou des motifs en forme de champignon, chaque motif (33) en forme de champignon comprenant un pilier (33a) surmonté d'un chapeau (33b), le chapeau ayant, dans un plan parallèle au substrat (10), des dimensions supérieures à celles du pilier, une première partie des motifs (33) étant formés du matériau polymère (32) électriquement isolant et une deuxième partie des motifs (33) étant électriquement conducteurs et appartenant à la zone électriquement conductrice (31).

2. Structure (1) selon la revendication 1, dans laquelle :
- le pilier (33a) des motifs (33) présente une hauteur comprise entre 5 µm et 200 µm et des dimensions comprises entre 1 µm et 100 µm dans un plan parallèle au substrat (10) ;
- le chapeau (33b) des motifs (33) présente une hauteur comprise entre 1 µm et 2 µm et, dans un plan parallèle au substrat (10), des dimensions maximales égales aux dimensions du pilier (33a) augmentées d'une valeur comprise entre 1 µm et 6 µm.

3. Structure (1) selon l'une des revendications 1 et 2, dans laquelle les motifs (33) présentent un premier pas de répétition (P1) dans une première direction (D1) et un deuxième pas de répétition (P2) dans une deuxième direction (D2) différente de la première direction.

4. Structure (1) selon l'une quelconque des revendications 1 à 3, dans laquelle :
- le composant électronique (20) comprend un plot de connexion (21) ; et
- la zone électriquement conductrice (31) relie la piste électriquement conductrice (12), le plot de connexion ou le via conducteur du substrat (10) au plot de connexion (21) du composant électronique (20).

5. Structure (1) selon l'une quelconque des revendications 1 à 4, dans laquelle la zone électriquement conductrice (31) comprend des nanofils de carbone, des nanotubes de carbone, du noir de carbone, des particules métalliques ou du graphène.

6. Structure (1) selon l'une quelconque des revendications 1 à 5, dans laquelle le film d'interconnexion (30) est capable de subir, sans rompre, une flexion d'un rayon de courbure inférieur ou égal à 1000 mm.

7. Structure (1) selon l'une quelconque des revendications 1 à 6, dans laquelle le film d'interconnexion (30) est capable de s'allonger sous sollicitation mécanique de plus de 5 % sans rompre.

8. Structure (1) selon l'une quelconque des revendications 1 à 7, dans laquelle le matériau polymère (32) électriquement isolant est du parylène ou un élastomère, par exemple du polyuréthane, du polyuréthane-acrylate, du polyvinylsiloxane, du polypropylène, de l'acide polylactique-co-glycolique ou un élastomère de silicone tel que le polydiméthylsiloxane (PDMS) ou le silicone polyaddition.

9. Structure (1) selon l'une quelconque des revendications 1 à 8, dans laquelle le composant électronique (20) est recouvert entièrement par une couche d'encapsulation constituée du matériau polymère (32) électriquement isolant.

10. Procédé de fabrication d'une structure électronique (1) comprenant les étapes suivantes :
- fournir un film d'interconnexion (30) comprenant une première face (30a), une deuxième face (30b) opposée à la première face, une zone électriquement conductrice (31) s'étendant de la première face à la deuxième face et un matériau polymère (32) électriquement isolant enrobant la zone électriquement conductrice, au moins l'une des première et deuxième faces (30a, 30b) du film d'interconnexion (30) étant structurée de manière à former un film d'adhésif sec, ladite au moins une des première et deuxième faces (30a, 30b) présentant une pluralité de motifs (33), les motifs (33) étant des piliers de section croissante en s'éloignant d'un plan médian du film d'interconnexion (30) ou des motifs en forme de champignon, chaque motif (33) en forme de champignon comprenant un pilier (33a) surmonté d'un chapeau (33b), le chapeau ayant, dans un plan parallèle au substrat (10), des dimensions supérieures à celles du pilier, une première partie des motifs (33) étant formés du matériau polymère (32) électriquement isolant et une deuxième partie des motifs (33) étant électriquement conducteurs et appartenant à la zone électriquement conductrice (31) ;
- disposer le film d'interconnexion (30) sur un substrat (10) comprenant un film support (11) et une piste électriquement conductrice (12) disposée sur le film support (11) ou un plot de connexion s'étendant à l'intérieur du film support (11) ou un via conducteur s'étendant à l'intérieur du film support (11) ; et
- disposer un composant électronique (20) sur le film d'interconnexion (30), de sorte que le composant électronique soit relié électriquement et mécaniquement au substrat par le film d'interconnexion.

11. Procédé selon la revendication 10, dans lequel l'étape de fourniture du film d'interconnexion (30) comprend les sous-étapes suivantes :
- fournir un moule (80) comprenant des cavités (81) ;
- déposer un matériau électriquement conducteur dans une région du moule (80), formant ainsi une zone électriquement conductrice (31) ;
- déposer un matériau polymère (32) électriquement isolant dans le moule (80) de manière à enrober la zone électriquement conductrice (31) ; et
- démouler le film d'interconnexion (30).

## Patentansprüche

1. Elektronische Struktur (1), umfassend:
- ein Substrat (10) mit:
∘ einem Trägerfilm (11); und
∘ einer elektrisch leitenden Leiterbahn (12), die auf dem Trägerfilm (11) angeordnet ist, oder einen Anschlusspunkt, der sich innerhalb des Trägerfilms (11) erstreckt, oder eine leitende Durchkontaktierung, die sich innerhalb des Trägerfilms (11) erstreckt;
- ein elektronisches Bauteil (20);
- eine Verbindungsfolie (30), die zwischen dem Substrat (10) und dem elektronischen Bauteil (20) angeordnet ist und das elektronische Bauteil elektrisch und mechanisch mit dem Substrat verbindet, wobei die Verbindungsfolie (30) umfasst:
∘ eine erste Seite (30a);
∘ eine zweite Seite (30b), die der ersten Seite gegenüberliegt;
∘ einen elektrisch leitenden Bereich (31), der sich von der ersten Seite (30a) zur zweiten Seite (30b) erstreckt und eine elektrische Verbindung zwischen dem elektronischen Bauteil (20) und dem Substrat (10) herstellt;
∘ ein elektrisch isolierendes Polymermaterial (32), das den elektrisch leitenden Bereich (31) umhüllt,
wobei mindestens eine der ersten und zweiten Seiten (30a, 30b) der Verbindungsfolie (30) so strukturiert ist, dass sie eine Trockenklebefolie bildet, wobei die mindestens eine der ersten und zweiten Seiten (30a, 30b) eine Vielzahl von Mustern (33) aufweist, wobei die Muster (33) Säulen mit zunehmendem Querschnitt sind, die sich von einer Mittelebene des Verbindungsfilms (30) weg erstrecken, oder pilzförmige Muster, wobei jedes pilzförmige Muster (33) eine Säule (33a) mit einer Kappe (33b) darauf umfasst, wobei die Kappe in einer zum Substrat (10) parallelen Ebene größere Abmessungen als die Säule aufweist, wobei ein erster Teil der Muster (33) aus dem elektrisch isolierenden Polymermaterial (32) gebildet ist und ein zweiter Teil der Muster (33) elektrisch leitfähig ist und zum elektrisch leitfähigen Bereich (31) gehört.

2. Struktur (1) nach Anspruch 1, in der
- die Säule (33a) der Muster (33) eine Höhe zwischen 5 µm und 200 µm und Abmessungen zwischen 1 µm und 100 µm in einer zum Substrat (10) parallelen Ebene aufweist;
- die Kappe (33b) der Muster (33) eine Höhe zwischen 1 µm und 2 µm und in einer zum Substrat (10) parallelen Ebene maximale Abmessungen aufweist, die den Abmessungen der Säule (33a) zuzüglich eines Wertes zwischen 1 µm und 6 µm entsprechen.

3. Struktur (1) nach einem der Ansprüche 1 und 2, in der die Muster (33) einen ersten Wiederholungsabstand (P1) in einer ersten Richtung (D1) und einen zweiten Wiederholungsabstand (P2) in einer zweiten Richtung (D2) aufweisen, die sich von der ersten Richtung unterscheidet.

4. Struktur (1) nach einem der Ansprüche 1 bis 3, in der:
- das elektronische Bauteil (20) einen Anschlusspunkt (21) umfasst; und
- der elektrisch leitende Bereich (31) die elektrisch leitende Bahn (12), den Anschlusspunkt oder die leitende Durchkontaktierung des Substrats (10) mit dem Anschlusspunkt (21) des elektronischen Bauteils (20) verbindet.

5. Struktur (1) nach einem der Ansprüche 1 bis 4, in der der elektrisch leitende Bereich (31) Kohlenstoff-Nanodrähte, Kohlenstoff-Nanoröhren, Ruß, Metallpartikel oder Graphen umfasst.

6. Struktur (1) nach einem der Ansprüche 1 bis 5, in der die Verbindungsfolie (30) ohne zu brechen eine Biegung mit einem Krümmungsradius von weniger als oder gleich 1000 mm aushalten kann.

7. Struktur (1) nach einem der Ansprüche 1 bis 6, bei der die Verbindungsfolie (30) in der Lage ist, sich unter mechanischer Beanspruchung um mehr als 5 % zu dehnen, ohne zu brechen.

8. Struktur (1) nach einem der Ansprüche 1 bis 7, bei der das elektrisch isolierende Polymermaterial (32) Parylen oder ein Elastomer ist, beispielsweise Polyurethan, Polyurethan-Acrylat, Polyvinylsiloxan, Polypropylen, Polymilchsäure-Co-Glykolsäure oder ein Silikonelastomer wie Polydimethylsiloxan (PDMS) oder Polyadditionssilikon ist.

9. Struktur (1) nach einem der Ansprüche 1 bis 8, in der das elektronische Bauteil (20) vollständig von einer Einkapselungsschicht aus dem elektrisch isolierenden Polymermaterial (32) bedeckt ist.

10. Verfahren zur Herstellung einer elektronischen Struktur (1) mit den folgenden Schritten:
- Bereitstellen einer Verbindungsfolie (30) mit einer ersten Seite (30a), einer der ersten Seite gegenüberliegenden zweiten Seite (30b), einem elektrisch leitenden Bereich (31), der sich von der ersten Seite zur zweiten Seite erstreckt, und einem elektrisch isolierenden Polymermaterial (32), das den elektrisch leitenden Bereich umhüllt, wobei mindestens eine der ersten und zweiten Seiten (30a, 30b) der Verbindungsfolie (30) so strukturiert ist, dass sie eine Trockenklebefolie bildet, wobei die mindestens eine der ersten und zweiten Seiten (30a, 30b) eine Vielzahl von Mustern (33) aufweist, wobei die Muster (33) Säulen mit zunehmendem Querschnitt sind, die sich von einer Mittelebene der Verbindungsfolie (30) weg erstrecken, oder pilzförmige Muster, wobei jedes pilzförmige Muster (33) eine Säule (33a) umfasst, die von einer Kappe (33b) überragt wird, wobei die Kappe in einer zum Substrat (10) parallelen Ebene größere Abmessungen als die Säule aufweist, wobei ein erster Teil der Muster (33) aus dem elektrisch isolierenden Polymermaterial (32) gebildet ist und ein zweiter Teil der Muster (33) elektrisch leitfähig ist und zum elektrisch leitfähigen Bereich (31) gehört;
- Anordnen der Verbindungsfolie (30) auf einem Substrat (10), das eine Trägerfolie (11) und eine auf der Trägerfolie (11) angeordnete elektrisch leitende Leiterbahn (12) oder einen sich innerhalb der Trägerfolie (11) erstreckenden Anschlusspunkt oder eine sich innerhalb der Trägerfolie (11) erstreckende leitende Durchkontaktierung umfasst; und
- Anordnen eines elektronischen Bauteils (20) auf dem Verbindungsfilm (30), sodass das elektronische Bauteil durch den Verbindungsfilm elektrisch und mechanisch mit dem Substrat verbunden ist.

11. Verfahren nach Anspruch 10, bei dem der Schritt des Bereitstellens der Verbindungsfolie (30) die folgenden Teilschritte umfasst:
- Bereitstellen einer Form (80) mit Hohlräumen (81);
- Aufbringen eines elektrisch leitfähigen Materials in einem Bereich der Form (80), wodurch ein elektrisch leitfähiger Bereich (31) gebildet wird;
- Aufbringen eines elektrisch isolierenden Polymermaterials (32) in die Form (80), um den elektrisch leitenden Bereich (31) zu umhüllen; und
- Entformen der Verbindungsfolie (30).

## Claims

1. An electronic structure (1) comprising:
- a substrate (10) comprising:
∘ a support film (11); and
∘ an electrically conductive track (12) disposed on the support film (11) or a connection pad extending inside the support film (11) or a conductive via extending inside the support film (11);
- an electronic component (20); and
- an interconnection film (30) disposed between the substrate (10) and the electronic component (20), electrically and mechanically connecting the electronic component to the substrate, the interconnection film (30) comprising:
∘ a first face (30a);
∘ a second face (30b) opposite to the first face;
∘ an electrically conductive zone (31) extending from the first face (30a) to the second face (30b) and ensuring electrical connection between the electronic component (20) and the substrate (10);
∘ an electrically insulating polymer material (32) coating the electrically conductive zone (31),
at least one of the first and second faces (30a, 30b) of the interconnection film (30) being structured so as to form a dry adhesive film, said at least one of the first and second faces (30a, 30b) having a plurality of patterns (33), the patterns (33) being pillars with an increasing cross section away from a median plane of the interconnection film (30), or mushroom-shaped patterns, each mushroom-shaped pattern (33) comprising a pillar (33a) having a cap (33b) thereabove, the cap having, in a plane parallel to the substrate, dimensions greater than those of the pillar, a first part of the patterns (33) being formed by the electrically insulating polymer material (32) and a second part of the patterns (33) being electrically conductive and belonging to the electrically conductive zone (31).

2. The structure (1) according to claim 1, wherein:
- the pillar (33a) of the patterns (33) has a height of between 5 µm and 200 µm and dimensions of between 1 µm and 100 µm in a plane parallel to the substrate (10);
- the cap (33b) of the patterns (33) has a height of between 1 µm and 2 µm and, in a plane parallel to the substrate (10), maximum dimensions equal to the dimensions of the pillar (33a) increased by a value of between 1 µm and 6 µm.

3. The structure (1) according to one of claims 1 et 2, wherein the patterns (33) have a first repeat pitch (P1) in a first direction (D1) and a second repeat pitch (P2) in a second direction (D2) different from the first direction.

4. The structure (1) according to any of claims 1 to 3, wherein:
- the electronic component (20) comprises a connection pad (21); and
- the electrically conductive zone (31) connects the electrically conductive track (12), the connection pad or the conductive via of the substrate (10) to the connection pad (21) of the electronic component.

5. The structure (1) according to any of claims 1 to 4, wherein the electrically conductive zone (31) comprises carbon nanowires, carbon nanotubes, carbon black, metal particles or graphene.

6. The structure (1) according to any of claims 1 to 5, wherein the interconnection film (30) is capable of undergoing, without breaking, bending with a radius of curvature less than or equal to 1000 mm.

7. The structure (1) according to any of claims 1 to 6, wherein the interconnection film (30) is capable of elongating under mechanical load by more than 5% without breaking.

8. The structure (1) according to any of claims 1 to 7, wherein the electrically insulating polymer material (32) is parylene or an elastomer, for example polyurethane, polyurethane acrylate, polyvinylsiloxane, polypropylene, polylactic-co-glycolic acid or a silicone elastomer such as polydimethylsiloxane (PDMS) or polyaddition silicone.

9. The structure (1) according to any of claims 1 to 8, wherein the electronic component (20) is entirely covered with an encapsulation layer consisting of the electrically insulating polymer material (32).

10. A method for manufacturing an electronic structure (1) comprising the following steps of:
- providing an interconnection film (30) comprising a first face (30a), a second face (30b) opposite to the first face, an electrically conductive zone (31) extending from the first face to the second face and an electrically insulating polymer material (32) coating the electrically conductive zone, at least one of the first and second faces (30a, 30b) of the interconnection film (30) being structured so as to form a dry adhesive film, said at least one of the first and second faces (30a, 30b) having a plurality of patterns (33), the patterns (33) being pillars with an increasing cross section away from a median plane of the interconnection film (30), or mushroom-shaped patterns, each mushroom-shaped pattern (33) comprising a pillar (33a) having a cap (33b) thereabove, the cap having, in a plane parallel to the substrate, dimensions greater than those of the pillar, a first part of the patterns (33) being formed by the electrically insulating polymer material (32) and a second part of the patterns (33) being electrically conductive and belonging to the electrically conductive zone (31);
- disposing the interconnection film (30) on a substrate (10) comprising a support film (11) and an electrically conductive track (12) disposed on the support film (11) or a connection pad extending inside the support film (11) or a conductive via extending inside the support film (11); and
- disposing an electronic component (20) on the interconnection film (30), so that the electronic component is electrically and mechanically connected to the substrate by the interconnection film.

11. The method according to claim 10, wherein the step of providing the interconnection film (30) comprises the following sub-steps of:
- providing a mould (80) comprising cavities (81);
- depositing an electrically conductive material into a region of the mould (80), thus forming an electrically conductive zone (31);
- depositing an electrically insulating polymer material (32) into the mould (80) so as to coat the electrically conductive zone (31); and
- releasing the interconnection film (30) from the mould.
